# EUROPEAN PATENT APPLICATION

(11) **EP 4 411 790 A1**
(43) Date of publication of application: **07.08.2024**
(21) Application number: 23155186.2
(22) Date of filing: 06.02.2023
(51) Int. Cl.: H01L 21/3213, H01L 21/02

(54) **ANISOTROPIC ALUMINIUM ETCHING**

(71) Applicant: Nederlandse Organisatie voor toegepast-natuurwetenschappelijk Onderzoek TNO, 2595 DA 's-Gravenhage (NL); Technische Universiteit Delft, 2628 CN Delft (NL)
(72) Inventor: PAPADOPOULOS, Nikolaos, 2595 DA 's-Gravenhage (NL); KARWAL, Saurabh, 2595 DA 's-Gravenhage (NL); GOSWAMI, Srijit, 2600 AA Delft (NL)
(74) Representative: V.O.

(57) **Abstract**

The present disclosure relates to a process of chemical etching aluminum; a method of manufacturing integrated circuit device, preferably qubit device; a use of the method or the device for the manufacturing a superconducting qubit device or topological qubit; an integrated circuit device, preferably a qubit device, as obtainable by the disclosed process or method; and to system configured to perform at least the process cycle of the process. The process (100) of chemical etching the layer comprising aluminum (1), comprises one or more exposure to a process cycle (102) including the steps of: fluorination (102a) of surface species of the layer by exposing the layer to a fluorine containing plasma (2); and removal of formed (102b) fluorinated species by dissolution thereof in an appropriate solvent (3).

## Description

### TECHNICAL FIELD AND BACKGROUND

The present disclosure relates to a process of etching films. comprising aluminum. The present disclosure further relates to a tool configured to perform the process, a method of manufacturing a semiconductor product, and to formed microfabricated integrated circuit products, especially quantum computing products.

Aluminum is a strategic metal whose superconducting properties play a major role in quantum technologies. Aluminum is used in superconducting qubits and in prospect topological qubit devices. So far, the etching of aluminum films generally relies on chemical solutions like tetramethylammonium hydroxide (TMAH) and specific aluminum etchants like (HF, BOE, Aluminum etchant type A or D as available from Transene^{®}).

In addition there are, so-called, dry etching approaches with chlorine based RIE (reactive ion etching) or argon milling.

Atomic layer etching (ALE) has been presented as a method of etching aluminum oxide. John Hennessy et al (Journal of Vacuum Science & Technology A: Vacuum, Surfaces, and Films 35, 041512 (2017)) describes ALE procedure based on alternating exposures of trimethylaluminum and anhydrous hydrogen fluoride (HF) to controllably etch aluminum oxide. Andreas Fischer et al (J. Vac. Sci. Technol. A 38, 022603, (2020)) describes thermal etching of AlF₃ with dimethyl-aluminum chloride and thermal isotropic atomic layer etching of Al₂O₃ with alternating exposures of HF and DMAC. Nicholas J. Chittock, et al (Appl. Phys. Lett. 117, 162107 (2020)) concerns a plasma-based ALE process for isotropic etching of Al₂O₃ involving SF₆-plasma and trimethylaluminium pulses as an alternative to thermal atomic layer etching with a higher etch rate.

However, for the manufacture of microfabricated devices comprising high resolution etched and/or patterned aluminum films the known methods involve several limitations, especially the presence of a plurality of other materials and (buried)layers. These limitations include, but not limited to: under etching; limited selectivity; poor stopping power; reliance on reagents and/or temperatures that are damaging to and/or that lead to undesired contamination and/or migration of elements between various parts of the device.

### SUMMARY

The present application aims to address one or more of the above limitations.

Aspects of the present disclosure relate to: a process of chemical etching aluminum; a method of manufacturing integrated circuit device, preferably a qubit device; a use of the process or the device for the manufacturing a superconducting qubit device or topological qubit; an integrated circuit device, preferably a qubit device, as obtainable by the disclosed process or method; and to system configured to perform at least the etching process cycle as disclosed herein.

As will become clear form the specification below the process enables controlled etching and patterning of aluminum containing films with accurate control over etching depth, under comparatively mild conditions. The process can be of particular benefit in microfabrication of thin metal films, e.g. for the manufacture of circuit elements of integrated circuit device such as for superconducting qubits and/or topological qubit devices with elements formed of thin metal tracks comprising or essentially consisting of aluminum. Of course, the process can also be applied to advantage in other fields including but not limited to processes for manufacturing of devices benefiting from high precision patterning or thinning down of aluminum-based films.

The etching process comprises an exposure of the layer or a substrate with layer comprising aluminum to a process cycle that includes the steps of: i) fluorination of surface species of the layer; and ii) removal of formed fluorinated surface species, wherein fluorination is typically provided by exposing the layer to a fluorine containing plasma resulting in the formation of fluorinated surface species, and wherein the removal comprises dissolution of formed fluorinated species in an appropriate liquid medium, typically by exposure to an aqueous solvent.

Processes or method as disclosed herein may be preceded by a step of providing a substrate having a metal layer that comprises or essentially consists of aluminum. The metal layer may, but need not be, pre-patterned.

Exposure of the metal layer, typically having a native or otherwise induced oxide surface finish, to the fluorine containing plasma is found to lead to the fluorination of surface species, which results in the formation of solid reaction products as AlF₃ and optionally fluorinated aluminum oxides. Inventors found that the formed fluorinated reaction products can be effectively dissolved in water, e.g. by dipping the substrate in a water bath for an appropriate amount of time. The exposure to water advantageously results in oxidation exposed surface metal species.

In addition and as compared to known methods the fluorination and removal of fluorinated species can be performed under particularly mild reaction conditions, using mild solvents, and while keeping sample processing temperatures < 100°C. This advantageously allows manufacture of sensitive devices/structures, e.g. structures with temperature sensitive elements or elements with limited stability in presence of common liquid etchants (e.g. strong acids).

The fluorine containing plasma can in principle be formed by any known methods, including glow discharge method (DC or low-freq RF or microwave), capacitively coupled plasma method, inductively coupled plasma, cascaded methods, corona discharge, dielectric barrier discharge (DBD). The fluorine containing plasma can be sourced from precursors known in the field, and an optional inert carrier gas. Inventors found that O₂ can be present in small amounts, e.g. up to 10 or 20 vol% relative to the fluorine precursors. For example, etching was confirmed in processes operating with 2 sccm of O₂ and 20 sccm or more of CF₄.

Preferably, the plasma is a fluorine-rich plasma, e.g. a plasma comprising fluorine and an optional carrier gas. The plasma preferably has no or only a minor content (≤ 5 vol%, preferably ≤ 1 vol%) of other active plasma species (that react with Al/AlOx). The higher the fluorine concentration the shorter an exposure can be.

The fluorine containing plasma can be a remotely formed plasma. The plasma can be guided to the substrate by a carrier flow as known in the field. Employing a remote plasma (as opposed to exposing the substrate to direct plasma discharge) advantageously mitigates physical direct etching phenomena, e.g. as a result of impact with high energy species/ions or electric discharge. A DC-bias (to direct the plasma) can be applied but is not required.

Advantageously the temperature of the substrate can remain under 100°C during the entire processing cycle(s). In a preferred embodiment, the temperature of the solvent, at least during contact with the substrate, does not exceed 90°, preferably does not exceed 40°C. Advantageously the temperature of the substrate can even be lower, e.g. at room temperature (25°C), during the washing and/or during the washing and plasma exposure. Limiting the process temperature (as compared to known processes) advantageously mitigates migration of volatile species (including Al) during processing, which can be of particular relevance for applications with a thin Al-based metal layer including, but not limited to, superconducting qubits and in prospect topological qubit devices.

Of course the process can be performed at higher temperatures, e.g. ≥ 90°C or more, to increase a dissolution rate of fluorinated surface species. In principle, the dissolution step can be eliminated by heating up to a vaporization temperature of AlF₃ (e.g. 250°C). However, in case of sensitive substrates and/or to limit Al migration high heat is not preferred.

The disclosure further relates to a method of manufacturing an integrated circuit device, preferably qubit device. The method comprises at least the steps of: providing a substrate having a layer comprising aluminum, and exposing the layer to one or exposures of the process cycle as disclosed herein.

In a preferred embodiment, the method further comprises a step of masking. Masking comprising a step of providing a mask covering portions of the layer in a predefined pattern so as to shield the covered portions of the layer during the one or more process cycle from exposure to the fluorine containing plasma and the solvent. Masks, e.g. having a thickness and composition withstanding effective loss of shielding properties upon subsequent exposure(s) to plasma and solvent, as well as method of providing and selective removal of such mask are known in the field. Suitability of can be confirmed by routine experimentartion.

The disclosure further relates to an integrated circuit device, e.g. a semiconductor device as obtainable by the process or the method as disclosed herein. In a preferred embodiment, the device can be a qubit device. The device comprising a circuit element formed of a metal layer comprising aluminum a thinned down to within a specified range using the disclosed process. The layer can advantageously be thinned down (by an appropriate number of etching cycles) so that its thickness does not exceed 10 nm. Advantageously the layer can be even thinner while remaining of consistent quality, e.g. in terms of having a conductivity comparable to conductivity of the layer prior to thinning. Thickness can be ≤ 7nm, or even thinner such a ≤ 3 or ≤ 2 nm. For example, the process can be worked to reliable form a thinned section having a thickness within a range of 1 to 10 nm, 2 to 10 nm, 1 to 7 nm, 2 to 7 nm, 1or 3 nm, or 2 to 3 nm. Due to the anisotropic etching qualities of the process the thinned down portion can be characterized by having an essentially stepwise transition between the thinned section and an adjacent remainder of the layer (e.g. a vertical etch profile).

The present disclosure further relates to a system configured to perform at least the process cycle as disclosed herein. The system can be comprised of an assembly of one or more modules configured to perform one or more specific steps of the process as disclosed herein. The system preferably includes a controller that can programmed to cause the one or more modules to perform the one or more, preferably all, of the process steps as disclosed herein.

The system includes at least a module for exposing a metal layer comprising aluminum to a fluorine plasma, a washing module for removing formed fluorinated surface species by dissolution in an appropriate solvent, and one or more optional rinsing and/or drying module.

The exposure module comprises an exposure chamber typically having holder for holding a target having a layer comprising aluminum; and a plasma generator fluidly connected to the exposure chamber for exposing the layer to a fluid comprising fluorine containing plasma and an optional inert carrier gas. The exposure module can be a commercially available plasma device.

The washing module is configured to expose the layer to liquid medium removing by dissolution of fluorinated reaction products in said medium.

In a preferred embodiment, the system can include a drying module configured for drying the substrate following exposure to the liquid medium and prior to any subsequent exposure to the plasma as foreseen. The exposure device can be further configured to perform the drying, e. by exposing the substrate to one or more inert gas streams, optionally at a reduced pressure.

Further or additional aspects relate to the use of the process, method, and/or the device for the manufacturing of a superconducting qubit device or topological qubit. Said use comprising repeatedly performing the process cycle process cycle (102) according to any of claims 1-10 so as to thin down a metal layer comprising aluminum until reaching a predetermined thickness.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 provides schematic representation of a process of chemical etching a layer comprising aluminum;
FIG 2 schematically illustrates a system configured to perform a chemical etching process cycle;
FIG 3A and 3B respectively provide cross-section side views of a sample prior to and after fluorination;
FIG 4 illustrates aspects of a sample during removal of formed fluorinated species by dissolution in a liquid medium;
FIG 5 provides a cross-section side view illustrating aspects of manufacturing an integrated circuit device; and
FIG 6; FIG7; and FIG 8 provide experimental details.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

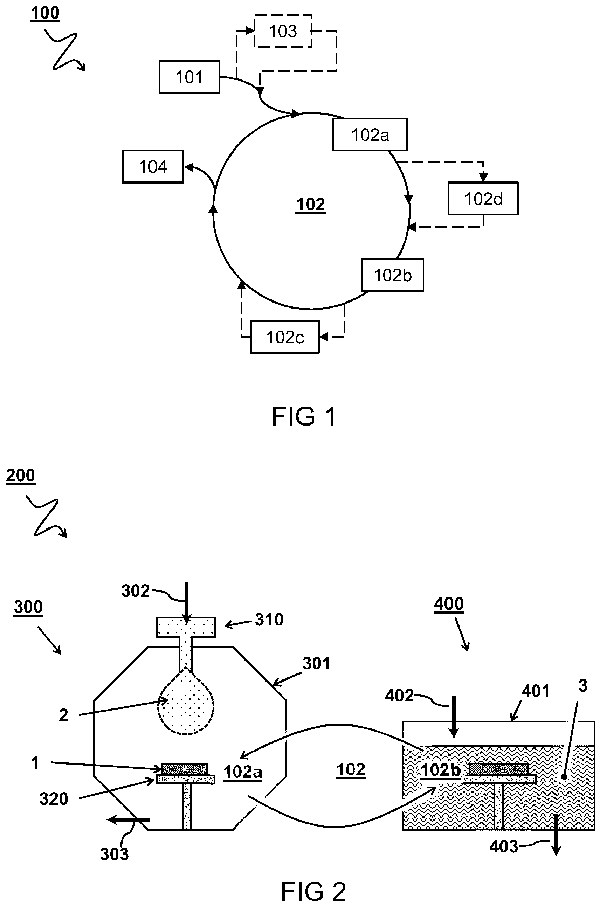

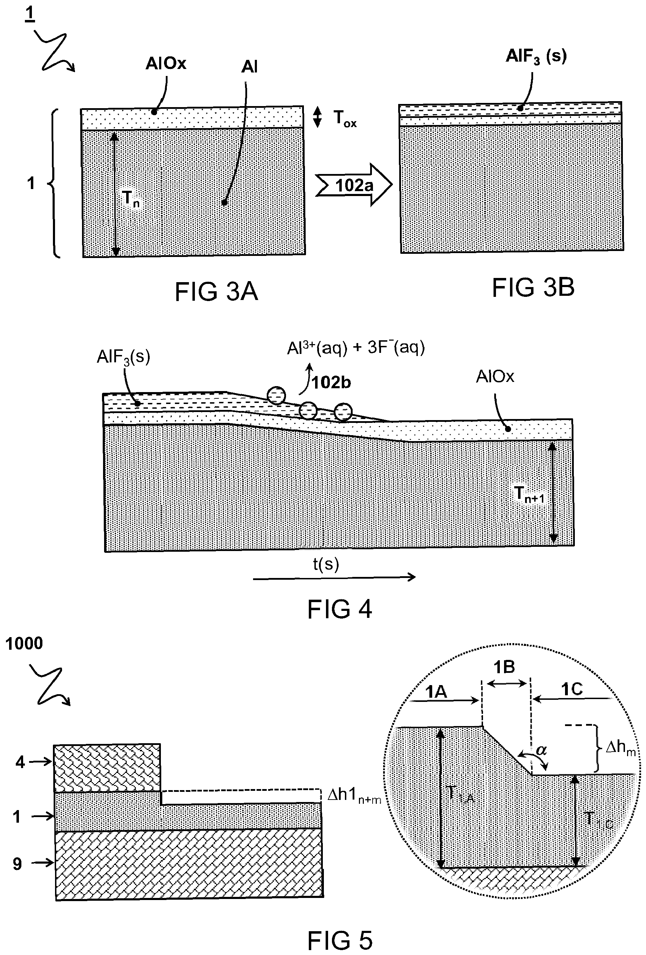

The process of chemical etching a layer comprising aluminum will now be illustrated with reference to FIGs 1-4, wherein FIG 1 provides a schematic illustration of a process 100 of a layer 1 comprising aluminum, wherein FIG 2 schematically illustrates a system 200 configured to perform a etching process cycle; and wherein FIGs 3 and 4 provide schematic cross section sideviews of the layer 1 at various stages of processing.

As illustrated in FIG 1 the process 100 of chemical etching aluminum, includes a process cycle 102 comprising the steps of: fluorination 102a; and subsequent removal 102b of formed fluorinated reaction products.

As illustrated in FIG 2 the fluorination 102a and removal 102b can be performed in a system 200 configured to perform the steps of fluorination and removal. The fluorination can be performed by exposing the layer 1 to a fluorine containing plasma 2. As best seen in FIG 3A and 3B the fluorination was found to lead of a reaction wherein at least an AlOx surface cover layer (having an initial thickness Tox) is converted to solid AlF3.

The removal 102b of formed fluorinated reaction products can advantageously be performed by exposing the layer to an appropriate solvent, e.g. submerging or rinsing for an appropriate period.

In one embodiment, e.g. as shown in FIG 2, the system 200 comprises an exposure module 300 comprising an exposure chamber 301 having holder 302 for holding a target having a layer comprising aluminum 1; and a washing module 400 configured to expose the layer to a liquid medium 3 for removing by dissolution of fluorinated reaction products.

With further reference to FIG 3A, 3B and FIG 4 the etching cycle is further elaborated. FIG 3 illustrates a film 1 comprising an aluminum metal layer, having an initial thickness Tn, which is covered by a skin of native aluminum oxide cover. Upon exposure 102a to F-containing plasma the AlOx skin is converted to a AlF₃ and optional aluminum oxyfluoride species (FIG 3B). Without wishing to be bound by theory inventors find that, ppon exposure to water 102b the skin with solid fluorinated aluminum species become solubilized in the water exposes the underlying AlOx which increases its thickness by oxidizing the Al.. The thickness of the remaining aluminum metal layer (Tn+1) is thus effectively reduced.

The removal step, exemplified by a submerging in water, can optionally be followed by one or more rinsing steps, e.g. with solvents of increasing purity, to remove solvent and/or ion residues.

The etching cycle is believed to be self-limiting in the sense that the formed fluorinated products at the surface passivate and progressively hinder fluorination of sub-surface species and in that (re-)formed surface oxide species during or post washing hinder further oxidation of underlying metal. The thickness of the fluorinated products is believed to be about 1-2 nm. The disclosure was found to advantageously allow the removal, etching, of a controlled amount of the metal layer per process cycle. Inventors found, with complete fluorination and re-formation of a native oxide layer, an amount of typically 1-2 nm from can be removed per process cycle.

The liquid medium is typically a water-based solvent. Water based solvents can advantageously be comparatively mild. In some embodiments, the solvent can comprise additives such as pH- or ionic strength-modifiers, and/or wetting agents so as to promote wetting and/or increase an AlF₃ dissolution rates. In some embodiments, the solvent can be a mixture, e.g. a mixture comprising water and a lower alcohol (C1-C3), configured to dry with negligible residues.

In a preferred embodiment, the process cycle 102 is performed repeatedly. Repeating the process cycle, in combination with the well-defined etch depth per cycle (e.g. 1-2 nm per cycle) for a controlled number of times provides accurate control over etching depth and thus a thickness of a remaining metal layer. By performing the process cycle repeatedly the metal film can be thinned down effectively (e.g. with 1-2 nm steps per cycle) until a pre-determined thickness is reached after which the process can be terminated by retrieving 104 the etched product.

In some embodiments, e.g. as shown in FIG 1, the process can further comprise a step of drying the substrate following the exposure to the liquid medium. The drying advantageously prevents potential detrimental interaction between solvent residues and plasma during a subsequent exposure step. The removal of formed fluorinated species and optional rinsing/drying can take place in a single or two or more separate modules. The rinsing/drying can comprise exposing the substrate to one or more flows of solvents, e.g. solvent s having increasingly high purity and/or solvents with increasingly high vapor pressure. Drying may optionally involve provided under pressure (vacuum exposure) and/or exposure to an inert gas stream. For example, the sample may be dried by more or more vacuum exposure and/or exposure to inert gas streams, such as the inert carrier gas used in combination with remote plasma generation.

In another or further preferred embodiment, the process comprises one or more steps of monitoring progress of the etching process 102c by measuring a quality of the remaining layer after, or in between, the one or more repetitions of the process cycle 102. Various methods known in the field are available to monitor etching progress. For example, etching progress can be monitored by measuring conducting properties of the remaining metal film; measuring changes in the optical contrast, profilometry, EDX spectroscopy, and/or ellipsometry.

Alternatively, or in addition, the process can comprise a step of monitoring an extent of the surface fluorination 102d. Surface fluorination can e.g. be monitored by one or more infrared surface spectroscopy, EDX, optical spectroscopy of plasma (OES), and mass spectroscopy of the gas phase above the substrate or as exiting an exposure chamber during fluorination. In a preferred variation the monitoring can be performed beforehand, e.g. on a test substrate, so as to determine/optimize exposure conditions, including exposure temperature, time, and/or concentration of plasma. Similarly optimized removal conditions can be determined beforehand, optimized. This calibration routines can advantageously reduce an overall process cycle time.

In a preferred embodiment, the process can include a further a step of providing a mask 103 shielding predefined areas of the layer from exposure to the fluorine containing plasma. A mask can be applied prior to and/or in between subsequent process cycles to provide lateral definition to structure formed upon etching.

The process was found to advantageously offer highly isotropic etching performance, e.g. in combination with broad range of conventional masking layers. The method as disclosed herein thus mitigates or even essentially eliminates under-etching and/or over-etching phenomena, which can be particularly detrimental to pattern definition, especially for thin metal films, e.g. Al-films having a thickness < 10 nm.

FIG 5 provides a cross-section side view of a patterned substrate illustrating aspects of manufacturing an integrated circuit device 1000. The figure schematically illustrates a half-product having a carrier substrate 9 with a layer 1 comprising aluminum after performing the etching cycle described above for "m" times. The product 1000 is shown (FIG 5-left) with a masking layer 4 in place. For ease of understanding any AlOx layers are not depicted.

Inventors found that the highly isotropic etching of the metal film 1 with virtually no under etching can leave a product with a metal layer having an essentially stepwise transition between a thinned section and an adjacent remainder of the layer. As best seen in in FIG 5 (right) a transition region (1B) between non-etched regions (1A, still having an initial thickness T1,A) and thinned down portions (1C, having a target thickness T1,C reduced by Δh following m-etching cycles) can be essentially step wise, e.g. having essentially right angles α (90° ± 5° or even 90° ± 2°).

The isotropic etching process can be stopped in accordance with a target pre-determined thickness of the remaining metal. If needed etch depth can be controlled by routine measurements.

As shown the exposure module 300 typically comprises a plasma generator 302 that is fluidly connected to the exposure chamber for exposing the layer to a fluid comprising fluorine containing plasma 2 and an optional inert carrier gas. Both the 300 and the 400 typically comprise corresponding inlets 302, 402 and outlets 402, 403. The exposure module 300 can be a commercially available plasma exposure system.

In a preferred embodiment, e.g. as shown, the system includes a remote plasma generator 310 fluidly connected to the exposure chamber a301 nd configured to guide the generated plasma to the target, e.g. by means of a carrier flow comprising an inert carrier gas.

In a preferred embodiment, the system comprises an automated means (e.g. a robot arm) configured to repeatedly transfer the target between the exposure and washing module and an optional drying module (not illustrated). In some embodiments the exposure module can be configured to dry the target prior to plasma exposure, e.g. by exposure to a stream of dry carrier gas.

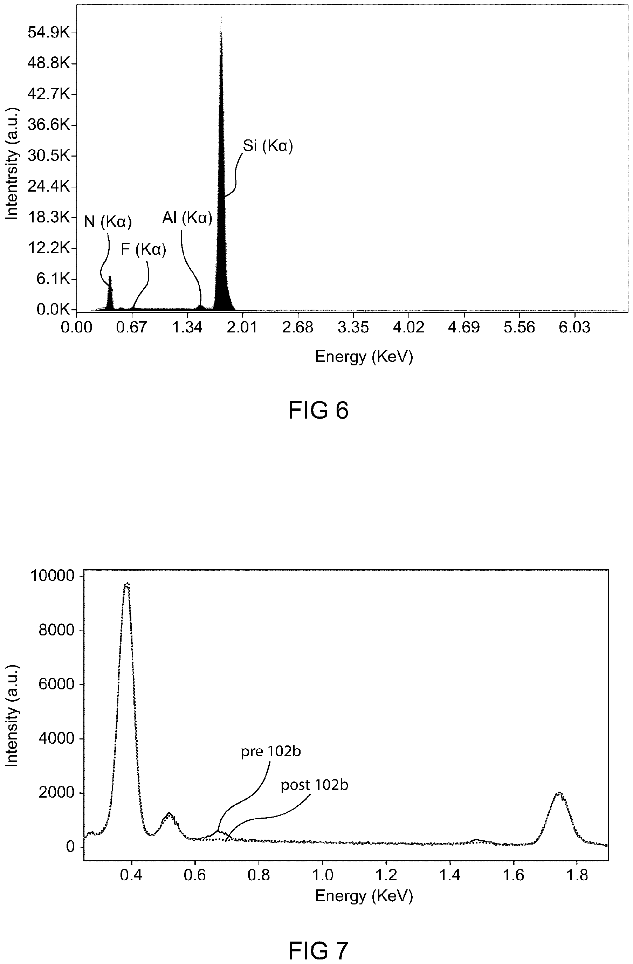

FIG 6; FIG7; and FIG 8 provide experimental details. FIG 6 depicts an EDX spectrum of a sample comprising an Al-layer as recorded directly after fluorination 102. FIG 7 depicts EDX spectra illustrating the surface composition of a sample comprising an Al-layer as recorded directly after a step of fluorination but before removal (marked pre 102b) and directly after dissolution of fluorinated species in water for 120 min at 50 _{°}C (marked post 102b). For both samples thin films of aluminum have been formed by electron beam deposition on a substrate comprised of Si/SiO₂ and Si/Si₃N₄. As illustrated fluorination/washing can be followed by appearance and complete removal of an Al(Kα) peak at about 0.67 keV. The peak of the remaining elements (N/Si/Al) are not noticeably affected.

Fluorination was confirmed on commercial plasma etchers (by Sentech and Tepla) under varying settings. The power was varied between: 30-300 W. The flow was varied between 10-250 sccm. Treatment time was varied between 1-5 min. Comparable results were obtained for CF₄-plasma, SF₆,-plasma, and CHF₃-plasma, with and without presence of a DC bias. Inventors confirmed that percentage of formed AlF₃ on the surface is time and power dependent, whereby higher values were found to saturate the surface faster. To mitigate ion-sputtering of the sample longer exposure times (low power) are preferred. At zero DC bias sputtering was avoided.

Removal of AlF₃ was performed by immersing the sample after plasma treatment in deionized water. Dissolution of fluorinated products was followed by EDX. After immersion for 10 min at 50 °C an F-peak was still found indicating incomplete removal of the AlF₃ film. After 2h (at 50°C) the complete removal of AlF₃ was confirmed (see, trace marked 'post 102b' in figure 7). Dissolution rates were confirmed to be temperature dependent, with lower times requiring increasingly long exposure (6h at 25°C) and higher temperatures leading to complete dissolution in shorter periods.

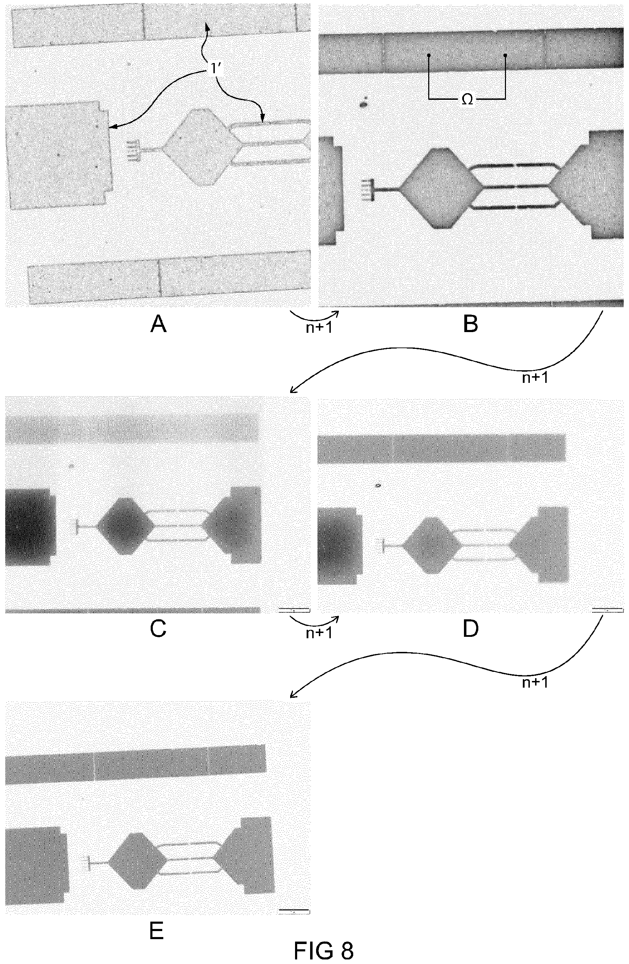

The process was further illustrated on substrates having 7 nm thick aluminum nanostructures 1'. FIGs 8A through E depict micrographs of the substrate after each of a total of five cycles (n) of fluorination and submerging in H₂O (each 20 min at 25 °C). Besides differences in image contrast of the Al structures, the etching was followed by monitoring the electrical conductance (R) of the aluminum structures. Only after the fifth cycle (FIG 8e) tracks were found to electrically insulating from having essential bulk metal resistivity (Ω) following the first (8A) , second (8B), third (8C), and the fourth process cycle (8D). This is in line with an observed etch rate of about 1-2 nm per process cycle.

For the purpose of clarity and a concise description, features are described herein as part of the same or separate embodiments, however, it will be appreciated that the scope of the invention may include embodiments having combinations of all or some of the features described. For example, while embodiments were shown for films comprising or essentially consisting of Al also alternative ways may be envisaged by those skilled in the art having the benefit of the present disclosure for achieving a similar function and result. E.g. the process can be applied to metal films comprising Al-based alloy. In particular the process can be applied to metals having fluorinated reaction products with an appreciable solubility in aqueous solvents. The process can also be applied to compositions comprising elements with volatile fluorinated reaction products such as Si including Al-Si alloys.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A process (100) of chemical etching a layer comprising aluminum (1), the process comprising one or more exposure to a process cycle (102) including the steps of:
i) fluorination (102a) of surface species of the layer by exposing the layer to a fluorine containing plasma (2); and
ii) removal of formed (102b) fluorinated species by dissolution thereof in a liquid medium (3).

2. The process according to claim 1, wherein the fluorine containing plasma (2) is a remotely formed plasma.

3. The process according to claim 1 or 2, wherein the solvent (3) is water.

4. The process according to any of the preceding claims, wherein process cycle (102) is performed repeatedly until a thickness of the metal film is in a range of 2-10 nm.

5. The process according to any of the preceding claims, further comprising a step of drying the substrate (1) following removal (102b) by dissolution of formed reaction products in the medium and prior to any subsequent fluorination.

6. The process according to any of the preceding claims, wherein the temperature of the medium (3), at least during contact with the substrate, does not exceed 90°, preferably does not exceed 40°C.

7. The process according to any of the preceding claims, comprising monitoring (120c) progress of the etching process by measuring a quality of the remaining layer after a completion of the process cycle.

8. The process according to any of the preceding claims, comprising a step of determining (102d) exposure conditions for the fluorination, said determining comprising monitoring a degree of fluorination by infrared surface spectroscopy.

9. The process according to any of the preceding claims, wherein the fluorine containing plasma (2) is formed from one or more of CF₄, CHF₄, and/or SF₆, and an optional inert carrier gas.

10. The process according to any of the preceding claims, wherein the layer (1) comprises an alloy of aluminum and silicon.

11. A method of manufacturing integrated circuit device, preferably qubit device, comprising:
providing (101) a substrate having a layer comprising aluminum (1), and
exposing the layer to one or more of the process cycle (102) according to any of claims 1-10.

12. The method according to the preceding claim, further comprising a step of providing (103) a mask (4) covering portions of the layer in a predefined pattern so as to shield covered portions of the layer during the one or more process cycle from exposure to the fluorine containing plasma and the liquid medium.

13. An integrated circuit device (1000), preferably a qubit device, preferably obtainable by the process or the method according to any of claims 1-12, said device comprising a circuit element formed of a thinned section of a metal layer comprising aluminum (1), wherein a thickness of the layer does not exceed 10 nm, preferably ≤ 7nm, most preferably ≤ 3, and having an essentially stepwise transition between the thinned section and an adjacent remainder of the layer.

14. A system (200) configured to perform at least the process cycle of the process according to any of claims 1-10, the device including:
an exposure module (300) comprising
an exposure chamber (301) having holder (302) for holding a target having a layer comprising aluminum (1); and
a plasma generator (302) fluidly connected to the exposure chamber for exposing the layer to a fluid comprising fluorine containing plasma (2) and an optional inert carrier gas, and
a washing module (400) configured to expose the layer to a liquid medium (3) for removing by dissolution of fluorinated reaction products.

15. Use of the method or the device according to any of the preceding claims for the manufacturing a superconducting qubit device or topological qubit, said use comprising repeatedly performing the process cycle process cycle (102) according to any of claims 1-10 so as to thin down a metal layer comprising aluminum until reaching a predetermined thickness.
